(19) Europäisches Patentamt
European Patent Office
Office européen des brevets

(11) EP 2 476 143 B1

(12) **FASCICULE DE BREVET EUROPEEN**

(45) Date de publication et mention de la délivrance du brevet:
**11.11.2015 Bulletin 2015/46**

(21) Numéro de dépôt: **10762711.9**

(22) Date de dépôt: **03.09.2010**

(51) Int Cl.:
*H01L 31/09* (2006.01)    *H01L 31/0352* (2006.01)
*H01L 31/0232* (2014.01)    *G01N 22/00* (2006.01)

(86) Numéro de dépôt international:
**PCT/FR2010/000600**

(87) Numéro de publication internationale:
**WO 2011/030011 (17.03.2011 Gazette 2011/11)**

(54) **PHOTOMELANGEUR POUR LA GENERATION DE RAYONNEMENT TERAHERTZ**

LICHTMISCHER ZUR ERZEUGUNG VON TERAHERTZ-STRAHLUNG

LIGHT MIXER FOR GENERATING TERAHERTZ RADIATION

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **09.09.2009 FR 0904298**

(43) Date de publication de la demande:
**18.07.2012 Bulletin 2012/29**

(73) Titulaire: **Centre National de la Recherche Scientifique**
**75016 Paris (FR)**

(72) Inventeurs:
• **PEYTAVIT, Emilien**
**F-59110 La Madeleine (FR)**
• **LAMPIN, Jean-François**
**F-59242 Templeuve (FR)**

(74) Mandataire: **Reboussin, Yohann Mickaël Noël et al**
**Cabinet Orès**
**36, rue de St Pétersbourg**
**75008 Paris (FR)**

(56) Documents cités:
**US-A- 5 455 421**    **US-A- 5 512 763**

• **PEYTAVIT E ET AL: "An ultra-wide bandwidth photomixer with down conversion at terahertz frequency", TERAHERTZ ELECTRONICS PROCEEDINGS, 2002. IEEE TENTH INTERNATIONAL CONF ERENCE ON 9 - 10 SEP 2002, PISCATAWAY, NJ, USA,IEEE, 9 septembre 2002 (2002-09-09), pages 23-26, XP010605622, ISBN: 978-0-7803-7630-4**
• **TAYLOR Z D ET AL: "RESONANT-OPTICAL-CAVITY PHOTOCONDUCTIVE SWITCH WITH 0.5% CONVERSION EFFICIENCY AND 1.0 W PEAK POWER", OPTICS LETTERS, OSA, OPTICAL SOCIETY OF AMERICA, WASHINGTON, DC, US LNKD- DOI:10.1364/OL. 31.001729, vol. 31, no. 11, 1 juin 2006 (2006-06-01), pages 1729-1731, XP001242591, ISSN: 0146-9592**

## Description

L'invention porte sur un photomélangeur et sur une source de rayonnement Terahertz basée sur un tel photomélangeur.

On indique par l'expression « rayonnement Terahertz » le rayonnement électromagnétique de fréquence comprise entre 100 GHz et 10 THz (1 THz=$10^{12}$ Hz) environ, ce qui correspond à des longueurs d'ondes comprises entre 3 mm et 30 $\mu$m environ. Située entre le domaine optique et celui des micro-ondes, cette plage spectrale a longtemps été sous-exploitée, notamment en raison de l'absence de sources et détecteurs adaptés.

L'exploitation du rayonnement Terahertz est aujourd'hui en plein développement au niveau industriel et commercial La spectroscopie Terahertz en constitue l'application principale. C'est ainsi que les premiers systèmes commerciaux de spectroscopie Terahertz large bande ont fait leur apparition sur le marché. Parmi les sociétés pionnières en ce domaine on peut citer Picometrix (États-Unis), Teraview (Royaume-Uni) en collaboration avec Brucker Optics, Nikon (Japon), Kwele (France), Gigaoptics (Allemagne), Tray-science (Canada), Eskpla (Lituanie). Certaines de ces entreprises commercialisent aussi des antennes de génération et détection d'impulsions Terahertz: Eskpla, Gigaoptics ou encore Tray-science

Ces systèmes de spectroscopie utilisent tous une technique dite « pompe-sonde » reposant sur un laser impulsionnel femtoseconde qui permet de faire une mesure sur une large bande spectrale mais avec une faible résolution (>1 GHz). Cette technique permet de générer et de détecter des impulsions électromagnétiques ayant une durée de l'ordre de la picoseconde et comprenant donc des composantes spectrales allant jusqu'à quelques THz.

Une autre technique de génération de rayonnement THz, très prometteuse pour les applications spectroscopiques, est le photomélange, c'est à dire le mélange de deux lasers infrarouge sur un photodétecteur ultra-rapide.

Les deux faisceaux lasers superposés, de fréquences $f_1$ et $f_2$, engendrent un battement à la fréquence f=| $f_1$ - $f_2$|, choisie dans le domaine Terahertz (100 GHz$\leq$ f $\leq$10 THz). Le photocourant généré par le photodétecteur comprend un terme constant et un terme oscillant de fréquence f : $I=I_0(1+\cos(2\pi\,f\,t))$. Le photodétecteur est couplé à une antenne, qui émet un rayonnement électromagnétique de fréquence f. L'ensemble constitué par le photodétecteur et l'antenne est indiqué par le terme « photomélangeur ».

Cette technique a été décrite pour la première fois dans l'article de E. R. Brown, K. A. McIntosh, K. B. Nichols et C. L. Dennis « Photomixing up to 3.8 THz in low-temperature-grown GaAs », Appl. Phys. Lett. 66, 285 (1995). Elle a pour avantage de présenter une meilleure résolution spectrale (<1 GHz) et d'être potentiellement portable car utilisable avec des diodes lasers à semi-conducteurs entre 700 et 1600 nm (0,7 - 1,6 $\mu$m) suivant le photodétecteur utilisé.

Les photodétecteurs normalement utilisés pour générer du rayonnement Terahertz par photomélange sont principalement:

- à $\lambda$=0,7 - 0,8 $\mu$m : des photorésistances utilisant un matériau à temps de vie court tels que l'arséniure de gallium épitaxié à basse température (AsGa BT).
- à $\lambda$=1,55 - 1,6 $\mu$m : des photodiodes à transport unipolaire (photodiodes UTC) ou des photorésistances utilisant un matériau à temps de vie court tel que l'InGaAs irradié.
- à $\lambda$=0,8 - 1,06 $\mu$m, longueur d'onde à laquelle fonctionnent des amplificateurs fibrés dopés à l'Ytterbium, des photorésistances en GaSb$_x$As$_{1-x}$ BT (avec 0<x<1, la valeur de x permettant de modifier la bande d'absorption du matériau).

Les performances obtenues en génération sont en général de l'ordre de 1 $\mu$W à 1 THz pour une puissance optique de l'ordre de 50 à 100 mW que ce soit à 0,8 $\mu$m ou à 1,55 $\mu$m. Les meilleurs résultats à 1 THz (2,6 $\mu$W à 1.05 THz en 2003) ont été obtenus à 1,55 $\mu$m avec une diode UTC couplée à une antenne log-périodique : voir l'article de Ito, H.; Nakajima, F.; Furuta, T.; Yoshino, K.; Hirota, Y.; Ishibashi, T., « Photonic Terahertz-wave génération using antenna-integrated » Electronics Letters, vol.39, no.25, pp. 1828-1829, 11 Décembre 2003.

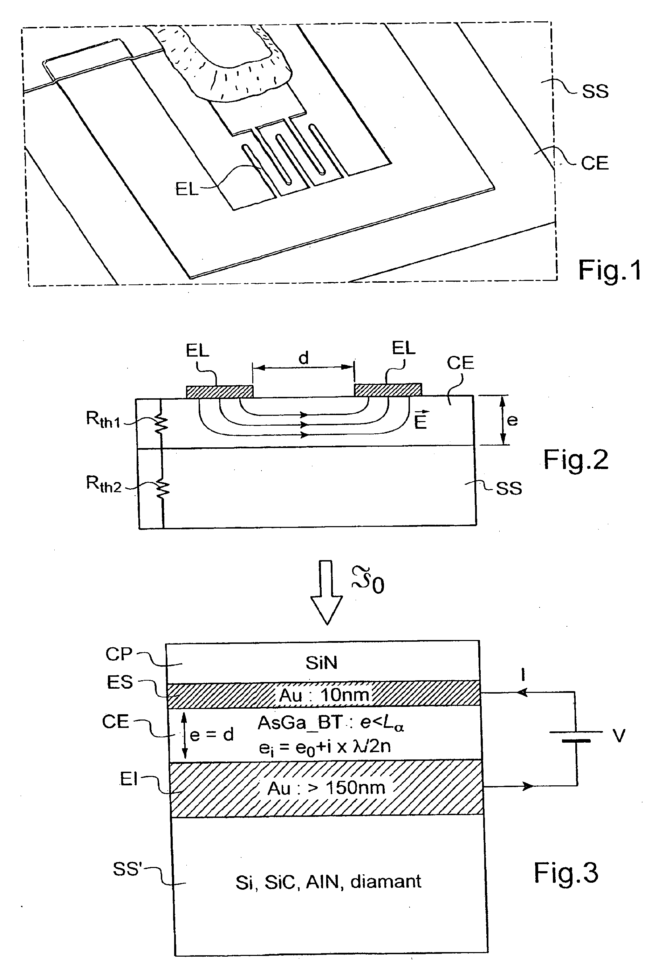

Les photodétecteurs en AsGa BT présentent généralement une structure planaire constituée par des électrodes métalliques interdigitées déposées sur une couche épitaxiale de l'AsGa BT (voir la figure 1). Un photodétecteur typique est composé de 5 électrodes métalliques de 0,4 $\mu$m de largeur et de 10 $\mu$m de long séparées de 1,8 $\mu$m. La surface totale du photodétecteur est de 88 $\mu$m$^2$.

Les puissances émises par les photomélangeurs, de l'ordre de 1 $\mu$W à 1 THz, sont encore largement insuffisantes pour les applications de type spectroscopie. En effet, les seuls détecteurs large bande suffisamment sensibles pour détecter ce niveau de puissance avec un bon rapport signal à bruit (>1000) sont les détecteurs bolométriques fonctionnant à 4 K. Une augmentation de la puissance générée permettrait d'utiliser des détecteurs à température ambiante.

La puissance THz émise par les photodétecteurs existants est limitée par des effets thermiques, comme cela a été montré par S. Verghese, K. A. McIntosh et E. R. Brown dans l'article « Optical and Terahertz power limits in the low-temperature-grown GaAs photomixers », Appl. Phys. Lett. 71, 2743 (1997). Pour une tension de polarisation donnée, lorsque l'on augmente progressivement la puissance optique, la destruction des photodétecteurs intervient avant que n'apparaissent des phénomènes de saturation, que ce soit en courant continu ou en puissance THz.

Il pourrait sembler évident d'augmenter la surface des photodétecteurs pour pouvoir s'affranchir de ces limites de puissance. Cependant, si les dimensions transversales du photodétecteur ne sont pas petites par rapport à la longueur d'onde du rayonnement Terahertz, les contributions des différents éléments de surface du détecteur peuvent interférer de manière destructive. Pour éviter cet effet on a eu recours à des structures planaires dites « distribuées », dans lesquelles le photodétecteur est intégré à un guide d'onde THz. Voir par exemple :

- E. A. Michael, B. Vowinkel, R. Schieder, M. Mikulics, M. Marso et P. Kordos « Large-area travelling-wave photonic mixers for increased continuous Terahertz power », Appl. Phys. Lett. 86, 111120 (2005) ; et
- M. Mikulics, E. A. Michael, R. Schieder, J. Stutzki, R. Gusten, M. Marso, A. van der Hart, H. P. Bochem, H. Luth et P. Kordos, « Travelling-wave photomixer with recessed interdigitated contacts on low-temperature-grown GaAs » Appl. Phys. Lett. 88, 041118 (2006).

Malheureusement la complexité de ces structures ne permet pas d'en exploiter tout le potentiel. La puissance maximale générée à 1 THz est de l'ordre de 1 $\mu$W, c'est à dire sensiblement la même que pour un photodétecteur « ponctuel », mais avec un moins bon rendement.

L'invention vise à surmonter les limitations précitées de l'art antérieur, notamment en termes de puissance maximale générée.

Conformément à l'invention un tel but est atteint par un photomélangeur pour la génération de rayonnement Terahertz comportant un photodétecteur couplé à une antenne pour rayonnement Terahertz, caractérisé en ce que ledit photodétecteur comporte une couche de matériau photoconducteur susceptible d'absorber un rayonnement optique, ladite couche présentant une épaisseur inférieure à la longueur d'absorption de ce rayonnement par le matériau photoconducteur et étant comprise entre une électrode, dite supérieure, au moins partiellement transparente et une électrode, dite inférieure, réfléchissante, lesdites électrodes inférieure et supérieure formant une cavité résonante pour ledit rayonnement optique. En plus de leur fonction optique, les électrodes servent à polariser le détecteur en appliquant une tension à la structure. Un tel photomélangeur présente des propriétés thermiques meilleures que celles des dispositifs de l'art antérieur, et peut donc fonctionner à des niveaux de puissance plus élevés.

Le document US 5,455,421 décrit un détecteur infrarouge présentant une structure semblable à celle du photodétecteur utilisé dans le photomélangeur de l'invention. Dans ce document, l'utilisation d'une couche active mince, insérée dans une cavité résonante, est préconisée pour augmenter la sensibilité du détecteur et réduire son niveau de bruit. Il s'agit là de considérations sans pertinence pour une utilisation en tant que photomélangeur Terahertz.

Des modes de réalisation particuliers du photomélangeur de l'invention font l'objet des revendications dépendantes.

Un autre objet de l'invention est une source de rayonnement Terahertz comportant un tel photomélangeur et au moins une source de rayonnement laser agencée pour diriger deux faisceaux ($F_1$, $F_2$) de rayonnement laser superposés sur l'électrode supérieure du photodétecteur, lesdits faisceaux de rayonnement laser présentant une différence de fréquence comprise entre 100 GHz et 10 THz.

Encore un autre objet de l'invention est l'utilisation d'un photomélangeur tels que décrits ci-dessus pour la génération de rayonnement Therahertz par photomélange.

L'invention permet la génération de rayonnement Terahertz avec une puissance de l'ordre de 1 mW à quelques milliwatts, soit une augmentation de trois ordres de grandeur par rapport à l'art antérieur.

D'autres caractéristiques, détails et avantages de l'invention ressortiront à la lecture de la description faite en référence aux dessins annexés donnés à titre d'exemple et qui représentent, respectivement :

- La figure 1, une image obtenue au microscope électronique à balayage d'un photodétecteur ultra-rapide de l'art antérieur ;
- La figure 2, une représentation schématique, en coupe, du photodétecteur de la figure 1 ;
- La figure 3, une représentation schématique, en coupe, d'un photodétecteur selon un mode de réalisation de l'invention ;
- La figure 4, un graphique montrant la dépendance du rendement optique du photodétecteur de la figure 3 en fonction de l'épaisseur de sa couche de matériau photoconducteur ;
- La figure 5, un graphique de la résistance thermique du photodétecteur de la figure 3 en fonction de l'épaisseur de sa couche de matériau photoconducteur ;
- La figure 6, une représentation schématique, en coupe, d'un dispositif de mesure du coefficient de réponse d'un photodétecteur du type de la figure 3 ;
- La figure 7, des valeurs du coefficient de réponse d'un photodétecteur du type de la figure 3 mesurés expérimentalement à l'aide du dispositif de la figure 6 ;

3

- La figure 8, un graphique montrant les valeurs du photocourant d'un photodétecteur selon un mode de réalisation de l'invention en fonction de la tension de polarisation pour différentes puissances optiques ;
- La figure 9, une représentation schématique, en coupe, d'un photodétecteur selon un mode de réalisation de l'invention, destinée à illustrer sa modélisation électrique ;
- La figure 10, un schéma illustrant la méthode des matrices de transfert, utilisée pour la modélisation optique d'un photodétecteur selon un mode de réalisation de l'invention ;
- La figure 11, une représentation schématique, en coupe, d'un photodétecteur selon un mode de réalisation de l'invention, destinée à illustrer sa modélisation thermique ;
- La figure 12, une représentation schématique, en coupe, d'un photodétecteur selon un mode de réalisation alternatif de l'invention ;
- La figure 13, une représentation schématique, en coupe, d'un photomélangeur selon un mode de réalisation de l'invention ; et
- La figure 14, une représentation schématique d'une source de rayonnement Terahertz selon un mode de réalisation de l'invention.

La figure 1 montre une image, obtenue au microscope électronique à balayage, d'un photodétecteur ultra-rapide connu de l'art antérieur comportant :

- une couche épitaxiale CE en AsGa BT déposée sur un substrat SS en AsGa semi-isolant ; et
- cinq électrodes métalliques interdigitées EL, déposées sur ladite couche CE, présentant une largeur de 0,4 $\mu$m et une longueur de 10 $\mu$m, séparées de 1,8 $\mu$m de manière à définir une surface active de 88 $\mu$m$^2$.

En première approximation, la puissance générée à une fréquence f dans la gamme THz par un photomélangeur basé sur le détecteur de la figure 1 est donnée par:

$$P_{THz} = \frac{1}{2} \frac{R_A I_0^{\,2}}{(1 + (\omega R_A C)^2)(1 + \omega^2 \tau^2)}$$

où :

- $I_0$ est le photocourant continu ;
- $R_A$ est la résistance de rayonnement, qui dépend de l'antenne couplée au photodétecteur ;
- C est la capacité des électrodes ;
- $\tau$ est le temps de vie des porteurs photogénérés ; et
- $\omega = 2\pi f$.

Cette équation montre que la bande passante du photodétecteur est gouvernée par deux temps caractéristiques :

- $\tau$, temps de vie des porteurs, caractéristique du matériau photoconducteur ; et
- $R_A C$, constant de temps électrique.

Deux fréquences de coupure, $fc_1 = 1/(2\pi\tau)$ et $fc_2 = 1/(2\pi R_A C)$, sont associées à ces constantes de temps.

Le gain du photodétecteur est donné par $R_A I_0^2$.

On peut définir un coefficient de réponse intrinsèque du photodétecteur $\mathfrak{R}_i(V)$ tel que :

$$I_0 = \mathfrak{R}(V) \times \eta_{opt} \times P_0 = \mathfrak{R}(V) \times P_{abs}$$

$\mathfrak{R}_i(V)$ croît avec la tension de polarisation V jusqu'à $\mathfrak{R}_m$ pour une tension $V_m$ qui permet d'atteindre la vitesse de saturation des porteurs.

On définit le rendement optique $\eta_{opt}$ comme le rapport entre la puissance optique incidente ($P_0$) et la puissance

absorbée par le matériau photoconducteur ($P_{abs}$) et créant des paires électron-trou : $\eta_{opt} = \dfrac{P_{abs}}{P_0}$ .

De plus, si l'on suppose pour simplifier que le champ électrique est constant entre les électrodes, on a :
$V_m = E_{0sat} \times d$
Où:

- d est l'espace inter-électrode
- $E_{0sat}$ est le champ électrique de saturation de la vitesse des porteurs.

Une bande passante atteignant le THz est obtenue en utilisant un photoconducteur dont les porteurs photogénérés présentent des temps de vie inférieurs à une picoseconde, tel que l'AsGa épitaxié à basse température, et en limitant la capacité électrique du peigne d'électrodes métalliques à quelques femtofarads (fF). En outre, les dimensions du photodétecteur doivent être inférieures à la dizaine de microns afin de limiter les phénomènes d'interférence entre les courants générés par les différents éléments de surface de la couche active. L'impédance des antennes étant généralement de l'ordre de 50 à 100 Ohms, la constante $R_A C$ est aussi inférieure à une picoseconde. Plus précisément, le photodétecteur planaire de la figure 1 a les caractéristiques suivantes :

- 200 fs$<\tau<$1 ps =>160 GHz$<fc_1<$800 GHz
- 0,5 fF$<$C$<$3 fF, RA$\approx$50 Ohms 25 fs$<R_A C<$150 fs
- 6000 GHz $>fc_2>$1000 GHz
- d $\approx$2$\mu$m
- $R_m \approx$0.01-0.04 A/W et $\eta_{opt} \approx$1 avec une couche antireflet
- $P_0 \approx$100mW avant destruction thermique, $I_0 \approx$1 à 2 mA et $V_m \approx$20 V ;

Pour f=1 THz on a une puissance générée $P_{THz} \approx$1 $\mu$W.
On peut donc définir un rendement de conversion $\eta_g$ qui est le rapport entre la puissance THz émise et la somme des puissances électriques et optiques fournies:

$$\eta_g = \frac{P_{THz}}{I_0 \times V_m + P_0}$$

Pour les photoconducteurs de l'art antérieur $\eta_g \approx$0.001 %.
La destruction thermique du composant se produit en correspondance d'une élévation de température $\Delta T_m$ par rapport à la température ambiante, atteinte pour une puissance absorbée $P_{absm}$. D'après les équations de la thermique, en régime stationnaire :

$$\Delta T_m = P_{th} \times R_{th}$$

$$\Delta T_m = R_{th} (P_{absm} + I_{0m} \times V_m)$$

$$\Delta T_m = R_{th} \times I_{0m} (\frac{1}{\Re_m} + V_m)$$

où $R_{th}$ est la résistance thermique reliant le photodétecteur à la masse thermique qui reste à température ambiante (l'arrière du substrat), tandis que $P_{th}$ est la puissance thermique dissipée dans le photoconducteur, somme de la puissance absorbée dans le photodétecteur ($P_{abs}$) et de la puissance joule $P_{joule} = I_0 \times V_m$. On en déduit le photocourant maximum $I_{0m}$ :

$$I_{0m} = \frac{\Delta T_m}{R_{th}(\frac{1}{\mathfrak{R}_m} + V_m)}$$

Si l'on garde constantes les fréquences de coupure : $P_{THz} \propto I_0^2$.

D'autre part à matériau constant, $\Delta T_m$ est constant donc :

$$P_{THzm} \propto \frac{1}{\left[ R_{th}(\frac{1}{\mathfrak{R}_m} + V_m) \right]^2}$$

Il est donc indispensable pour dépasser le $\mu W$ au THz d'optimiser:

1 : Le rapport entre la puissance THz émise et la puissance thermique générée dans le photodétecteur. Cela revient, si l'on suppose que $\eta_{opt}$ est constant, à optimiser le rendement de conversion $\eta_g$. En effet, il suffit de remplacer $P_0$ par $P_{abs}$ pour passer de l'un à l'autre.

Il faut donc *augmenter* $\mathfrak{R}_m$ et *diminuer* $V_m$.

2 : L'évacuation de la puissance thermique afin de limiter l'élévation de la température du photodétecteur. Ce qui revient à *diminuer la résistance thermique* $R_{th}$ entre le photodétecteur et son environnement.

Les présents inventeurs ont démontré que, pour un matériau photoconducteur donné :

$$\mathfrak{R}_m \propto \frac{1}{d}$$

$$V_m \propto d$$

où **d** est la distance interélectrode. La démonstration sera présentée plus loin en référence au photodétecteur de l'invention, mais le résultat s'applique également à un photodétecteur dé l'art antérieur.

Dans le cas d'un photodétecteur planaire présenté figures 1 et 2, la distance interélectrode **d** et l'épaisseur **e** de la couche active CE dépendent de la longueur d'absorption (La) dans le matériau photoconducteur (AsGa-BT) qui est d'environ 0,7 $\mu m$ (à 1/e, « e » étant ici la base des logarithmes naturels) pour une longueur d'onde $\lambda=0,8$ $\mu m$.

Ainsi **e**~2 $\mu m$ au moins est nécessaire pour optimiser le rendement optique $\eta_{opt}$ mais aussi et surtout pour limiter l'absorption dans le substrat d'épitaxie SS en AsGa semi-isolant. Dans celui-ci, les porteurs ont un temps de vie supérieur d'un facteur 100 à 1000 par rapport au temps de vie dans l'AsGa-BT. Donc même une petite partie de la puissance optique incidente, parvenant jusqu'au substrat, pourrait y générer une densité de porteurs élevée et une densité de courant non modulée sous polarisation qui serait destructive.

La condition **d** ~2 $\mu m$ au moins est nécessaire pour avoir un champ électrique statique uniforme dans la zone d'absorption. En effet, l'application d'une différence de potentiel entre deux électrodes conductrices déposées sur la surface d'un semi-conducteur considéré comme un diélectrique produit un champ électrique statique non négligeable sur une profondeur quasiment égale à l'espace inter-électrode (voir les lignes de force du champ électrique $\vec{E}$ illustrées sur la figure 2). Ainsi pour avoir un champ électrique non négligeable sur une profondeur **e** de 2 $\mu m$, l'espace inter-électrode **d** doit être proche de cette valeur.

On peut voir que la structure d'un photodétecteur conventionnel ne permet pas de réduire la distance interélectrode **d** au-dessous d'une certaine valeur (2 $\mu m$ dans l'exemple considéré), et donc d'augmenter $\mathfrak{R}_m$ et/ou diminuer $V_m$.

D'un point de vue thermique, la résistance thermique totale $R_{th}$ peut être vue comme la somme de deux résistances thermiques en sérié ($R_{th1} + R_{th2}$), avec $R_{th1}$ la contribution de la couche active photoconductrice et $R_{th2}$ la

contribution du substrat. La contribution $R_{th1}$ dépend de l'épaisseur *e* de la couche active CE ; cette contribution est importante parce que le AsGa -BT a une faible conductivité thermique (20 W/m/K). Encore une fois, le fait de ne pas pouvoir réduire celle-ci au-dessous d'une certaine valeur (2 μm dans l'exemple considéré) limite les possibilités d'augmenter la puissance Terahertz générée par un photodétecteur de l'art antérieur.

Le photodétecteur selon l'invention, dont la structure est illustrée sur la figure 3, permet de réduire l'espace interélectrode *d* et l'épaisseur e de la couche active, optimisant ainsi les valeurs de $R_m$, $V_m$ et $R_{th}$ et par conséquent la puissance Terahertz pouvant être générée par photomélange.

Dans cette structure la couche active CE d'AsGa BT ou d'un autre matériau photoconducteur adapté est prise en sandwich entre deux couches métalliques (ES et EI) ayant peu de pertes dans l'infrarouge, tel que l'or, l'argent ou encore le cuivre. Ces deux couches métalliques ont en effet un double rôle. Elles ont un rôle au niveau électrique puisqu'elles servent d'électrodes de polarisation du photoconducteur, mais aussi au niveau optique, puisque elles forment une cavité optique résonnante. L'électrode inférieure EI joue le rôle de miroir métallique, tandis que la couche ES est semi-transparente, grâce à sa faible épaisseur, et permet de moduler la transmission de la puissance optique dans la cavité. L'épaisseur de la couche *e* et la distance interélectrode *d* sont ici confondues et peuvent être choisies telles que $e=d<L_\alpha$. En effet, il est possible par absorption résonnante, d'avoir un rendement optique proche de l'unité malgré une épaisseur faible. Une couche diélectrique CP transparente dans l'infrarouge peut être ajoutée en surface permettant de passiver le composant et/ou d'ajuster les propriétés optiques de la cavité résonnante (revêtement antireflet ou, au contraire, réfléchissant). Cette couche peut être, par exemple, du nitrure de silicium ($Si_xN_y$) mais aussi de l'oxyde de silicium ($Si_xO_y$).

L'électrode supérieure ES pourrait même être parfaitement transparente : dans ce cas, ce serait l'interface électrode/air, ou couche CP/air qui rendraient possible la réflexion partielle du rayonnement infrarouge permettant la résonance optique.

Cette structure permet également de reporter la couche épitaxiale d'AsGa - BT sur un autre substrat SS' par themocompression Au-Au ou par brasure à l'aide d'un eutectique Au-In ou Au-Sn. L'électrode métallique enterrée peut donc servir aussi de couche de « collage » entre la couche épitaxiale et un substrat hôte choisi pour ses propriétés thermiques. Avantageusement, le substrat SS' peut être choisi pour avoir une conductivité thermique plus élevée que l'AsGa utilisé dans le dispositif de la figure 1 (conductivité thermique de l'AsGa : 45 W/m/K).

Pour réaliser une telle structure on part d'un substrat en AsGa sur lequel on dépose par épitaxie une couche de GaInP et ensuite une couche de AsGa BT. Ensuite on métallise cette dernière couche par un dépôt en or, ainsi que le substrat hôte SS' (Si, SiC...) sur lequel le détecteur sera reporté. Puis on met en contact les deux faces métallisées et on applique une pression de quelques dizaines de bars (typiquement de l'ordre de 20 bars) à une température comprise entre 200 et 340 °C environ pendant quelques heures - typiquement 1 à 2 heures (thermocompression), ce qui conduit à une solidarisation des deux substrats. A ce point, on grave le substrat d'AsGa dans une solution chimique (par exemple un mélange de $H_2O_2$ et $H_2SO_4$) qui s'arrête sur la couche de GaInP. Cette dernière est gravée à son tour dans une deuxième solution chimique (par exemple une solution de HCl) qui n'attaque pas l'AsGa BT. On obtient donc une couche d'AsGa BT reportée sur le substrat hôte par l'intermédiaire d'une couche d'Au. Il ne reste ensuite qu'à déposer les couches constituant l'électrode supérieure semi-transparente ou transparente ainsi que le revêtement diélectrique éventuel.

Avantageusement, la conductivité thermique du matériau constituant le substrat SS' peut être supérieure à 100 W/m/K. Ce matériau peut être par exemple le Si (130 W/m/K), le SiC (6H) (490 W/m/K) ou, idéalement, le diamant (1100 W/m/K).

Le substrat SS' n'a pas d'influence au niveau optique puisque l'électrode inférieure EI est choisie de manière à être totalement réfléchissante. Ce substrat n'a pas non plus d'influence au niveau électrique, puisque l'électrode inférieure EI constitue également un blindage électromagnétique.

Un autre avantage de la structure de la figure 3 est que l'absorption du rayonnement infrarouge se fait de manière pratiquement homogène sur toute l'épaisseur de la couche active CE, ce qui n'est pas le cas de la structure planaire de l'art antérieur. Or, il est possible de montrer (ce qui sera fait plus loin) qu'une absorption homogène sur toute l'épaisseur de la couche est très avantageuse du point de vue thermique.

A titre d'exemple le photodétecteur de la figure 3 comporte :

- un substrat épais SS' en Si, SiC ou diamant ;
- une électrode inférieure EI en or (Au) d'épaisseur supérieure à 150 nm, par exemple 700 nm ;
- une couche CE en AsGa - BT d'épaisseur e inférieure au micromètre (la question de l'épaisseur de cette couche sera étudiée plus en détail par la suite) ;
- une électrode supérieure ES en or de 10 nm d'épaisseur ; et
- une couche de passivation CP en SiN.

Dans une telle structure, la distance *d* entre les électrodes EI et ES est nécessairement égale à *e*.

Ce détecteur, de type à photoconduction, a fait l'objet d'une modélisation optique, thermique et électrique, ainsi que d'une étude expérimentale pour en déterminer les performances.

La modélisation optique a été effectuée pour le cas d'une incidence normale du rayonnement optique (infrarouge) sur le détecteur, ce qui permet de ne considérer qu'une seule composante des champs E et H. En outre, on a considéré le problème unidimensionnel (les grandeurs physiques ne dépendent que de la profondeur z).

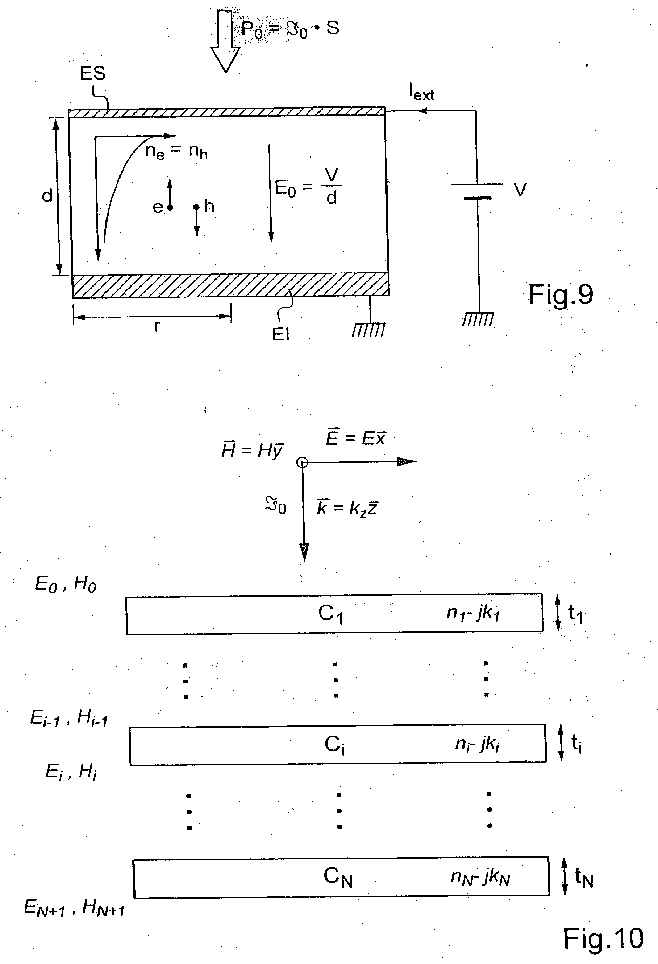

Le photodétecteur de surface S , assimilé à un empilement de couches minces $C_1$, ... $C_i$, ... $C_N$, caractérisées par leur épaisseurs $t_1$, ... $t_i$,...$t_N$, et par leurs indices de réfraction complexes (voir la figure 10) est éclairé uniformément par un faisceau de puissance $P_0$. La densité de puissance incidente $\Im_0 = P_0/S$.

La modélisation se base sur la méthode des matrices de transfert, bien connue en optique. Dans cette approche, les champs électriques ($\vec{E}$) et magnétiques ($\vec{H}$) de part et d'autre de chaque couche de la structure sont reliées par une matrice 2x2. Du fait de la continuité des composantes tangentielles des champs, les caractéristiques de la structure dans son ensemble s'obtiennent ensuite par la multiplication des matrices correspondant à chaque couche. Ainsi pour une couche d'épaisseur d, d'indice complexe $n_c$=n-jk (pour une longueur d'onde $\lambda$) et d'impédance d'onde $Z = \dfrac{Z_0}{n - jk}$

avec $Z_0$=377 $\Omega$ l'impédance du vide, on obtient :

$$\begin{bmatrix} E_i \\ H_i \end{bmatrix} = \begin{bmatrix} \cos(\dfrac{2\pi d}{\lambda}(n-jk)) & \dfrac{j}{Z}\sin(\dfrac{2\pi d}{\lambda}(n-jk)) \\ jZ\sin(\dfrac{2\pi d}{\lambda}(n-jk)) & \cos(\dfrac{2\pi d}{\lambda}(n-jk)) \end{bmatrix} \begin{bmatrix} E_{i-1} \\ H_{i-1} \end{bmatrix}$$

Par cette méthode, pour une densité de puissance optique incidente donnée $\Im_0$ (W/m$^2$), les grandeurs scalaires complexes E et H sont calculées à chaque interface mais aussi continûment dans la structure. Ce qui permet alors d'avoir la densité de puissance optique $\Im(z)$ qui se propage dans la structure d'après le théorème de Poynting :

$$\Im(z)\vec{z} = \frac{1}{2}\mathrm{Re}(E\vec{x} \times H^*\vec{y})$$

$$\Im(z)\vec{z} = \frac{1}{2}\mathrm{Re}(EH^*)$$

où « * » représente l'opérateur de conjugaison complexe.

La densité de puissance absorbée $\Pi_{abs}(z)$ dz dans une tranche d'épaisseur dz située en z est égale à :

$$\Pi_{abs}(z)\,dz = -\Im(z+dz) + \Im(z)$$

$$\Rightarrow \Pi_{abs}(z) = -\frac{\Im(z+dz) - \Im(z)}{dz}$$

$$\Rightarrow \lim_{dz \to 0} \Pi_{abs}(z) = -\frac{d\Im(z)}{dz}$$

$\Pi_{abs}(z)$ est la densité (volumique) de puissance absorbée en chaque point de la structure et s'exprime en W/m$^3$. Il suffit alors d'intégrer $\Pi_{abs}(z)$ sur la couche Ci pour avoir la puissance absorbée dans cette couche.

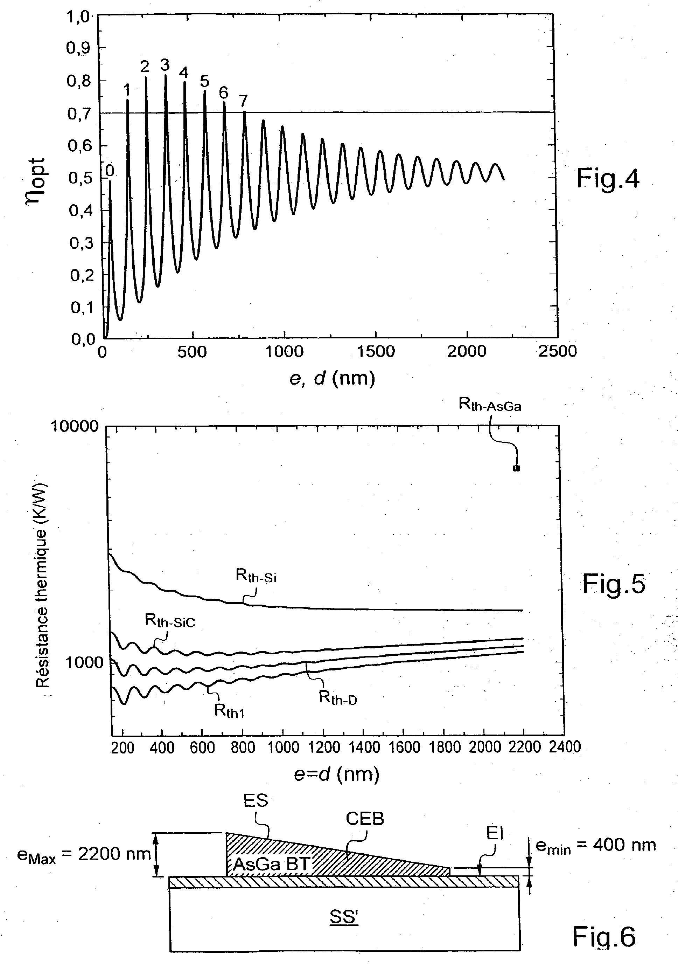

La figure 4 montré le rendement optique $\eta_{opt}$ du détecteur de la figure 3 calculé par la méthode des matrices de transfert en fonction de **e**. On peut voir que le tracé $\eta_{opt}$ se présente sous la forme d'une pluralité de pics de résonance, ce qui se comprend en remarquant que la structure de la figure 3 constitue, du point de vue optique, un étalon de Fabry-Pérot. Soit **e_0** l'épaisseur qui correspond à la résonance d'ordre zéro ; alors le pic de résonance d'ordre *i* correspond à une épaisseur $e_i = e_0 + i \cdot \lambda/2n$, n étant la partie réelle de l'indice de réfraction de la couche active CE. Dans l'exemple de la figure 4, $e_0$=47 nm, $\lambda/2n \approx$105 nm et donc $e_1$, $e_2$, $e_3$, etc. sont égales respectivement à 152 nm, 257 nm, 362 nm, etc. On peut voir sur la Figure 4 que l'absorption dans le photoconducteur est supérieure à 70 % de la puissance optique incidente pour $e_{1 \leq i \leq 7}$.

Ainsi, comparé à la structure planaire dans laquelle **e**=2000 nm, on obtient pour $e_1$=152 nm une amélioration d'un facteur 2000/152$\approx$13 pour $\mathfrak{R}_m$ et $V_m$ alors qu'il y'a une dégradation de $\eta_{opt}$ d'un facteur 0,7/ 1=0,7 par rapport à cette même structure planaire en considérant que cette dernière a un rendement optique maximum ($\eta_{opt}$=1).

Pour l'application à la génération de rayonnement Terahertz, il est nécessaire que la largeur spectrale des résonances soit suffisamment large pour permettre le photomélange de deux longueurs d'onde optiques différentes. Ainsi, on requiert que largeur à mi-hauteur des pics de résonance doit être au minimum égale à 100 GHz, et de préférence au moins égale à 1 THz. Cette conditions est très largement satisfaite dans l'exemple de la figure 4, où l'absorption ne varie que de 1 à 2% lorsque l'on passe de $\lambda$=0.77 $\mu$m à 0,79 $\mu$m ce qui correspond à une différence de fréquence $f \approx$ 10 THz.

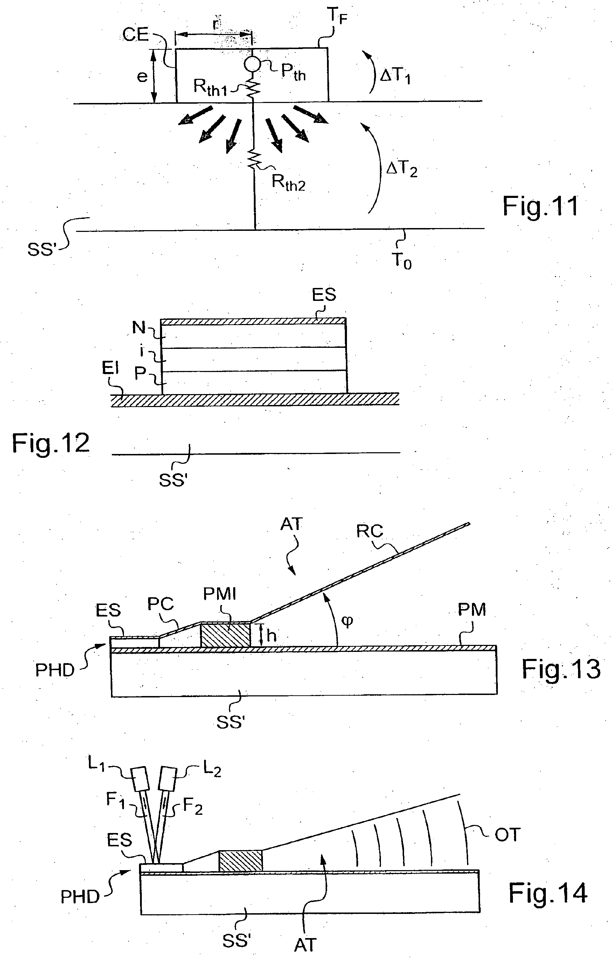

Pour calculer la résistance thermique on a modélisé le photodétecteur, supposé cylindrique de surface S, rayon r et hauteur sensiblement égale à **e**, par une source de chaleur de puissance thermique $P_{th}$ reliée à une masse thermique par une résistance thermique $R_{th=}$ $R_{th1}$+$R_{th2}$ (voir la figure 11). L'élévation de température $\Delta T = T_f T_0 = R_{th} \times P_{th}$ peut être vue comme la somme de deux élévations $\Delta T_1 = R_{th1} \times P_{th}$ et $\Delta T_2 = R_{th2} \times P_{th}$ qui correspond respectivement à la traversée de la couche CE d'AsGa BT et à « l'étalement » dans le substrat SS'.

Généralement $r >> e$, on peut donc considérer en première approximation que la température $T$ ne dépend que de la profondeur z. $R_{th1}$ peut donc être calculé en résolvant l'équation de la thermique à une dimension:

$$k_{AsGaBT} \frac{d^2 T}{dz^2} = \rho_{th}(z)$$

Avec $k_{AsGaBT}$ la conductivité thermique de l'AsGa BT et $\rho_{th}$ la densité de puissance dans le photodétecteur telle que :

$$S \times \int_0^e \rho_{th}(z)dz = P_{th} \cdot$$

En première approximation, il est possible de considérer que la puissance thermique est uniquement générée à la surface du photoconducteur et $\rho_{th}$ est donc nulle pour z$\neq$0. $R_{th1}$ est alors égal à :

$$R_{th1} = \frac{e}{k_{AsGaBT} \times S} \cdot$$

Toutefois, il apparaît clairement que la résistance thermique peut diminuer si la puissance thermique est générée sur l'ensemble de la couche d'AsGa-BT.

Ainsi si $\rho_{th}(z) = cste = \dfrac{P_{th}}{S \times e}$, alors $R_{th1} = \dfrac{1}{2} \dfrac{e}{k_{AsGaBT} \times S}$

Pour prendre en compte ce phénomène, on peut calculer la densité de puissance optique absorbée en fonction de z, $\Pi_{abs}(z)$ (voir plus haut) ainsi que la densité de puissance joule (voir plus bas) :

$$\Pi_{joule} = q \times (n_e + n_h) \times v_s \times E_0 = \Pi_{abs}(z) \times 2 \times q \times \tau \times \frac{1}{h\nu}$$

Et donc

$$\rho_{th}(z) = \Pi_{joule}(z) + \Pi_{abs}(z) = \Pi_{abs}(z) \times (1 + 2 \times q \times \tau \times \frac{1}{h\nu})$$

Une fois $\Delta T_1$ calculé, $R_{th1}$ est calculé en intégrant $\rho_{th}$ sur tout le volume du photodétecteur :

$$R_{th1} = \frac{\Delta T_1}{\iiint \rho_{th} \, dV}$$

Les dimensions du photodétecteur (~$\mu$m) étant très petites devant celles du substrat (~mm), la contribution $R_{th2}$ peut être modélisée par une résistance dite « d'étalement » (« spreading résistance ») d'une source ponctuelle dans un espace semi-infini. Pour un photodétecteur circulaire de rayon $r$, le problème possède une symétrie cylindrique et $R_{th2}$ est alors égale à :

$$R_{th2} = \frac{1}{\pi r \, k_{substrat}}$$

La figure 5 montre la valeur calculée de la résistance thermique totale pour le photodétecteur vertical résonnant de la figure 3 avec différents matériaux de substrat et en fonction de l'épaisseur de la couche active CE, pour une capacité électrostatique C constante de 3.2 fF correspondant à une fréquence de coupure $fc_2$= 1 THz pour $R_A$=50 $\Omega$. Ainsi, la courbe $R_{th1}$ représente la seule contribution de la couche active CE à la résistance thermique ; les courbes $R_{th-Si}$, $R_{th-SiC}$ et $R_{th-D}$ représentent la résistance thermique totale pour un photodétecteur présentant un substrat épais en Si, SiC et diamant respectivement. Le point $R_{th-AsGa}$ se rapporte à un détecteur à structure planaire (voir figures 1 et 2) avec un substrat en AsGa semi-isolant et une épaisseur $d$=2,2 $\mu$m.

En première approximation, dans la structure verticale de l'invention, $R_{th1}$ est inversement proportionnel à la capacité électrostatique C:

$$C = \frac{\varepsilon_0 \varepsilon r_{GaAs} S}{d} \quad et \quad R_{th1} \approx \frac{d}{k_{AsGaBT} S}$$

d'où
$$R_{th1} C \approx \frac{\varepsilon_0 \varepsilon r_{GaAs}}{k_{AsGaBT}}$$

avec

- $\varepsilon_{rAsGa}$, la permittivité diélectrique relative de l'AsGa-BT,
- $\varepsilon_0$, la permittivité diélectrique du vide,
- S, la surface du photodétecteur vertical résonnant, et
- $k_{AsGaBT}$, la conductivité thermique de l'AsGa-BT.

Par conséquent, pour C constant, $R_{th1}$ ne devrait pas dépendre de $e$. Toutefois, on peut voir sur la figure 5 que $R_{th1}$ n'est pas tout à fait constante car, comme cela a été expliqué plus haut, il est préférable d'un point de vue thermique d'absorber la puissance optique de manière homogène dans la couche. Ainsi $R_{th1}$ passe de 1100 K/W pour d=2200 nm à $\approx$700 K/W pour d=150 nm. D'autre part on peut voir qu'il est possible de diminuer $R_{th}$ d'un facteur 4 par rapport à la structure planaire avec du SiC ou du diamant et encore d'un facteur 2 sur du Si.

Une modélisation électrique, illustrée par la figure 9, permet le calcul de coefficient de réponse ($\mathfrak{R}_i$) du photodétecteur vertical de la figure 3. Pour calculer le coefficient de réponse $\mathfrak{R}_i$ il faut résoudre les équations de dérive-diffusion et de continuité dans le semi-conducteur sous éclairement. Dans le cas présent, lorsque $d$<<2r, on peut se ramener à un problème unidimensionnel dans lequel les grandeurs physiques, telles que $ne$ ($n_h$), la densité d'électrons (trous) ou $\mathfrak{I}_i$ la densité de puissance optique ne dépendent que de la profondeur z.

D'autre part on néglige l'effet de la densité de charge $q \times (n_h - n_e)$ (avec q=1.6 $\times 10^{-19}$ C) sur le champ électrique statique, ce dernier est donc constant dans la structure :

$$E_0 = \frac{V}{d}$$

De plus l'AsGa BT est un matériau à temps de vie des porteurs ($\tau$) sub-picoseconde et à faible mobilité ($\mu \approx 400$

cm$^2$/V/s) donc la longueur de diffusion $L_D$ est très courte. En effet $L_D$=(D×τ)$^{0,5}$ avec $D$=μ×$kT$/$q$≈10 cm$^2$/V/s le coefficient de diffusion et τ ≈1 ps d'où $L_D$≈30 nm. Cette longueur étant négligeable devant la longueur d'absorption, la longueur d'onde optique et les dimensions du photodétecteur, on peut donc négliger les processus de diffusion. Les densités de porteurs sont donc directement proportionnelles au taux de génération optique :

$$n_e(z) = n_h(z) = \Pi_{abs}(z) \times \tau \times \frac{1}{h\nu}$$

avec $hv$ : l'énergie photonique $hv$ =1,59 eV pour λ=0,78 μm et $\Pi_{abs}(z)$ est la densité de puissance absorbée.

En supposant que les électrons et les trous ont une vitesse de saturation $v_s$ identique, le courant de dérive $I(z)$ dans le composant à la profondeur z est égale à

$$I(z) = q[n_e(z) + n_h(z)] \times v_s \times S$$

$$I(z) = -2\frac{q}{h\upsilon}\Pi_{abs}(z) \times v_s \times S \times \tau$$

A ce point, en suivant le raisonnement de Feiginov (Michael N. Feiginov « Analysis of limitations of terahertz p-i-n uni-traveling-carrier photodiodes », J. Appl. Phys. 102, 084510 (2007)), on peut en déduire le courant $I_{ext}$, qui est la moyenne du courant de dérive dans la structure.

$$I_{ext} = \frac{1}{d}\int_0^d I(z)dz$$

D'où

$$I_{ext} = -\frac{2}{d}\int_0^d \frac{q}{h\upsilon}\Pi_{abs}(z) \times v_s \times S \times \tau \times dz$$

$$\Rightarrow I_{ext} = \frac{2}{d} \times \frac{q}{h\upsilon} \times P_{abs} \times v_s \times \tau$$

$$\Rightarrow \Re_m = \frac{I_{ext}}{P_{abs}} = \frac{A}{d}$$

Avec $A = 2 \times \frac{q}{h\upsilon} \times v_s \times \tau$ et $P_{abs} = \int_0^d \frac{q}{h\upsilon}\Pi_{abs}(z)dz$

On retrouve le résultat, annoncé plus haut, selon lequel le coefficient de réponse $\Re$ est inversement proportionnel à la distance interélectrode d.

En prenant pour l'AsGa BT : $v_s$ =0,7 10$^7$ cm/s et τ=800 fs on obtient A=70×10$^{-9}$ Am/W.

Afin d'évaluer le gain en terme de puissance THz générée, ont peut se placer juste avant la destruction du composant et reprendre l'expression du photocourant maximum $I_{0m}$ :

$$I_{0m} = \frac{\Delta T_m}{R_{th}(\frac{1}{\Re_m} + E_{0sat} \times d)}.$$

Comme $\Re_m = \dfrac{A}{d}$ , on peut écrire $I_{0m} = \dfrac{\Delta T_m}{R_{th} \times d \times (\frac{1}{A} + E_{0sat})}.$

A matériau photoconducteur constant $\Delta T_m$, Eosat et A sont constants. Donc si on appelle $I_{0mP}$ le courant maximum pour une structure planaire (selon l'art antérieur) d'épaisseur $d_P$=2000 nm et $I_{0mV}$ celui pour une structure verticale (selon l'invention) d'épaisseur $d_V$=150 nm, on trouve un rapport des résistances thermiques

$$\frac{R_{thP}}{R_{thV}} = 4 \implies \frac{I_{0mV}}{I_{0mP}} = \frac{R_{thP} \times d_P}{R_{thV} \times d_V} = 53.$$

La puissance THz générée étant proportionnelle au carré du photocourant, l'invention permet, au moins en principe, une augmentation d'un facteur $53^2 \approx 2800$ de la puissance générée à 1 THz.

Ces résultats ont été validés expérimentalement en mesurant en continu la réponse d'un photodétecteur vertical en fonction de la distance interelectrode $d$ sur une même couche d'AsGa-BT caractérisée par un temps de vie $\tau$ de porteurs photogénérés d'environ 800 fs. Cette variation d'épaisseur a été réalisée sur un même échantillon en faisant une gravure en « biseau » d'une couche CEB de GaAs-BT de 2,2 $\mu$m d'épaisseur reportée sur un substrat SS'. On a ainsi obtenu des épaisseurs allant de $e_{min}$=0,3 $\mu$m à $e_{max}$=2,2 $\mu$m. La structure testée est illustrée sur la figure 6. Les électrodes métalliques supérieure ES et inférieure EI sont en or et permettent de polariser la couche d'AsGa-BT.

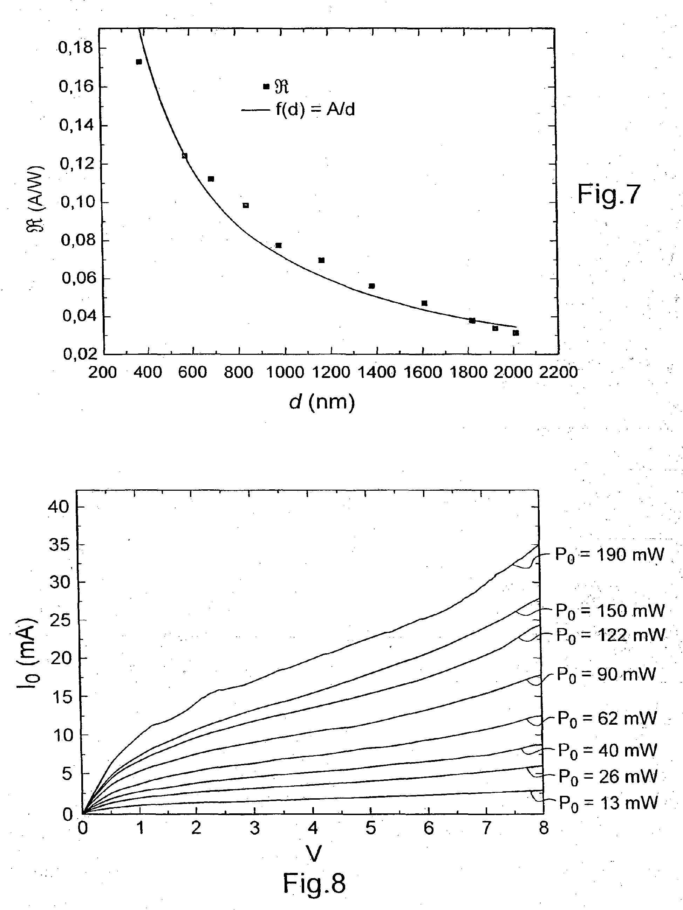

La figure 7 montre le coefficient de réponse $\Re_1$ mesuré en fonction de $d$ pour une tension de polarisation correspondant à un champ électrostatique $E_0$=50 KV/cm et une puissance optique $P_0$=10 mW. La réponse varie quasiment en 1/$d$ (ligne continue représentant la fonction A/d avec A=$7 \cdot 10^{-8}$ Am/W).

De plus, la figure 8 montre qu'un photocourant maximum de 35 mA pour une puissance optique $P_0$=190 mW peut être obtenu avec une distance inter électrode $d$=340 nm. Cette valeur est 10 à 20 fois supérieure aux courants obtenus sur des photodétecteurs planaires.

Jusqu'ici on a considéré le cas d'un photodétecteur de type à photorésistance, mais la portée de l'invention n'est pas limitée à ce type de dispositif. D'autres photodétecteurs convenant à la mise en oeuvre de l'invention sont, notamment, les photodiodes à transport unipolaire (dites « UTC », de l'anglais « uni-travelling carrier »). Il s'agit de photodiodes de type PiN dont le comportement dynamique n'est pas limité par les trous (généralement plus lents). Dans ce type de détecteur, l'absorption se fait dans la « base » de type P et pas dans la zone intrinsèque. Par exemple à $\lambda$=1,55 $\mu$m (c'est-à-dire une énergie photonique $E_{ph}$ de 0,8 eV), la base peut être en InGaAs qui présente une bande interdite $E_g < E_{ph}$ alors que la zone intrinsèque et la zone N peuvent être en InP de bande interdite $E_g > E_{ph}$.

La principale limitation de ces diodes, lorsqu'elles sont optimisées pour le photomélange, est leur faible absorption du flux lumineux (quelques pourcent). En effet, plus la zone absorbante est épaisse, plus le temps de diffusion des électrons est important. De plus, une grande partie du flux de photons est absorbée par la couche de titane généralement utilisée comme couche de contact de la zone P. Il est donc avantageux, conformément à l'invention, de mettre la zone P dans une cavité optique formée par les électrodes supérieure ES (semi-transparente) et inférieure EI (totalement réfléchissante), comme représenté sur la figure 12 ce qui permet aussi le report sur un substrat ayant une plus grande conductivité thermique.

L'invention pourrait s'appliquer également à des photodiodes PiN ordinaires, mais en général ces détecteurs ne sont pas assez rapides pour convenir à la génération par photomélange de rayonnement Terahertz.

Les matériaux photoconducteurs indiqués sont donnés uniquement à titre d'exemples non limitatifs ; d'autres matériaux photoconducteurs adaptés à la réalisation de photodétecteurs selon l'invention peuvent être identifiés par l'homme du métier.

Un « photomélangeur » est un dispositif comportant un photodétecteur ultrarapide PHD couplé avec une antenne Terahertz AT. Un photodétecteur à structure verticale peut être couplé avec des nombreuses antennes connues de l'art antérieur. Cependant, il est préférable de l'associer avec une antenne à cornet transverse électromagnétique, conçue par les présents inventeurs et décrite dans le document FR 2 908 931.

Une telle antenne AT comporte un plan de masse PM, formée par une couche métallique déposée sur un substrat isolant SS', et un ruban conducteur RC s'étendant au-dessus dudit plan de masse et formant un angle aigu $\varphi$

avec ce dernier. Avantageusement, le ruban RC s'élargit de sa base (à proximité du plan de masse) vers son extrémité, ce qui permet de maintenir son impédance constante (typiquement 50 Ω). Ce type d'antenne est intéressant car elle présente une large bande passante ; par conséquent, elle convient à la réalisation d'une source accordable de rayonnement Terahertz. En outre, il est facile d'associer une antenne à cornet transverse électromagnétique avec un photodétecteur à structure verticale tel que décrit ci-dessus. Cela est illustré sur la figure 13. Une couche en or épaisse PM constitue tant l'électrode inférieure du photodétecteur PHD que le plan de masse de l'antenne. Le ruban conducteur RC, également en or, est séparé de ce plan de masse par un plot PMI en matériau isolant (SiO$_2$, Si$_3$N$_4$, etc.) d'hauteur h généralement comprise entre 100 nm et 10 μm, et est connecté à l'électrode supérieure du photodétecteur par un « pont » métallique PC. Cette structure est « blindée » : il n'y a aucune perte par radiation dans le substrat.

La figure 14 montre une représentation schématique d'une source de rayonnement Terahertz constituée par un photomélangeur selon la figure 13 et deux sources de rayonnement laser L$_1$ et L$_2$. Les fréquences d'émission des sources L$_1$ et L$_2$ sont décalées de 100 GHz - 10 THz de manière à pouvoir engendrer un battement dans la plage Terahertz. Il peut s'agir de lasers à état solide ou à semi-conducteur, éventuellement accordables, et émettant de préférence dans le proche infrarouge (800 - 1550 nm). Les faisceaux de lumière F$_1$, F$_2$ émis par ces sources laser se superposent sur l'électrode supérieure ES du photodétecteur PHD pour générer le battement Terahertz. Ils peuvent y parvenir par propagation libre dans l'air ou par propagation guidée en fibre optique ou dans des guides planaires (optique intégrée). Comme expliqué plus haut, le battement des deux rayonnements lasers engendre dans le photodétecteur un photocourant comportant une composante à fréquence Terahertz, qui excite une onde électromagnétique OT de même fréquence dans l'antenne à cornet AT, qui est émise par l'extrémité libre de cette dernière.

En variante, il est possible d'utiliser une seule source laser oscillant sur deux modes longitudinaux dont la différence de fréquence est de l'ordre de 100 GHz - 10 THz. Ce mode de réalisation s'avère être très avantageux, notamment en raison du fait que les deux faisceaux, correspondant aux deux modes, sont nécessairement superposés et que leur différence de fréquence est plus stable que si deux sources indépendantes étaient utilisés.

## Revendications

1.  Photomélangeur pour la génération de rayonnement Terahertz comportant un photodétecteur (PHD) couplé à une antenne (AT) pour rayonnement Terahertz, **caractérisé en ce que** le photodétecteur comporte une couche (CE) de matériau photoconducteur susceptible d'absorber un rayonnement optique, ladite couche présentant une épaisseur (**e**) inférieure à la longueur d'absorption de ce rayonnement par le matériau photoconducteur et étant comprise entre une électrode (ES), dite supérieure, au moins partiellement transparente et une électrode (EI), dite inférieure, réfléchissante, lesdites électrodes inférieure et supérieure formant une cavité résonante pour ledit rayonnement optique.

2.  Photomélangeur selon la revendication 1, dans lequel ledit photodétecteur est reporté par l'intermédiaire de ladite électrode inférieure sur un substrat (SS') présentant une conductivité thermique supérieure à celle du matériau photoconducteur.

3.  Photomélangeur selon l'une des revendications précédentes, dans lequel ledit matériau photoconducteur est **caractérisé par** un temps de vie des porteurs de charge photogénérés inférieur à 10 ps et de préférence inférieur à 1 ps.

4.  Photomélangeur selon la revendication 3, dans lequel ledit matériau photoconducteur est choisi parmi le AsGa épitaxié à basse température (AsGa-BT), le GaSb$_x$As$_{1-x}$ BT (0<x<1) et le InGaAs irradié.

5.  Photomélangeur selon l'une des revendications précédentes, dans lequel ledit photodétecteur est d'un type choisi parmi un détecteur à photoconduction et une diode à transport unipolaire.

6.  Photomélangeur selon l'une des revendications précédentes, dans lequel ledit rayonnement optique est un rayonnement infrarouge, de préférence ayant une longueur d'onde comprise entre 700 et 1600 nm.

7.  Photomélangeur selon l'une des revendications précédentes, dans lequel ledit résonateur optique présente des pics de résonance de largeur à mi-hauteur supérieure ou égale à 100 GHz et de préférence supérieure ou égale à 1 THz.

8.  Photomélangeur selon l'une des revendications précédentes, dans lequel lesdites électrodes supérieure (ES) et inférieure (EI) sont des électrodes métalliques.

9. Photomélangeur selon l'une des revendications précédentes, comportant un revêtement diélectrique transparent (CP) au-dessus de ladite électrode supérieure (ES).

10. Photomélangeur selon l'une des revendications précédentes, dans lequel ladite couche de matériau photoconducteur (CE) présente une épaisseur (e) inférieure à 1 $\mu$m et de préférence inférieure à 500 nm.

11. Photomélangeur selon l'une des revendications précédentes dans lequel ladite antenne (AT) pour rayonnement Terahertz est du type à cornet transverse électromagnétique, comportant un plan de masse (PM) et un ruban conducteur (RC) s'étendant au-dessus dudit plan de masse et formant un angle aigu ($\varphi$) avec ce dernier.

12. Photomélangeur selon la revendication 11 dans lequel ledit photodétecteur (PHD) est reporté sur un substrat (SS') diélectrique ou semi-conducteur intrinsèque par l'intermédiaire de son électrode inférieure (EI) ; dans lequel le plan de masse (PM) de l'antenne est constitué par un prolongement de ladite électrode, s'étendant au-dessus dudit substrat ; et dans lequel le ruban conducteur (RC) s'étendant au-dessus dudit plan de masse est connecté électriquement à ladite électrode supérieure

13. Source de rayonnement Terahertz comportant un photomélangeur selon l'une des revendications précédentes et au moins une source de rayonnement laser ($L_1$, $L_2$) agencée pour diriger deux faisceaux ($F_1$, $F_2$) de rayonnement laser superposés sur l'électrode supérieure du photodétecteur, lesdits faisceaux de rayonnement laser présentant une différence de fréquence comprise entre 100 GHz et 10 THz.

14. Utilisation d'un photomélangeur selon l'une des revendications précédentes, pour la génération de rayonnement Therahertz par photomélange.

## Patentansprüche

1. Photomischer zur Erzeugung einer Terahertz-Strahlung, der einen mit einer Antenne (AT) für eine Terahertz-Strahlung gekoppelten Photodetektor (PHD) aufweist, **dadurch gekennzeichnet, dass** der Photodetektor eine Schicht (CE) aus photoleitendem Material aufweist, das eine optische Strahlung absorbieren kann, wobei die Schicht eine Dicke (e) geringer als die Absorptionslänge dieser Strahlung durch das photoleitende Material aufweist und zwischen einer zumindest teilweise transparenten so genannten oberen Elektrode (ES) und einer reflektierenden so genannten unteren Elektrode (EI) enthalten ist, wobei die untere und die obere Elektrode einen Resonanzhohlraum für die optische Strahlung bilden.

2. Photomischer nach Anspruch 1, wobei der Photodetektor mittels der unteren Elektrode auf ein Substrat (SS') übertragen wird, das eine höhere Wärmeleitfähigkeit als diejenige des photoleitenden Materials aufweist.

3. Photomischer nach einem der vorhergehenden Ansprüche, wobei das photoleitende Material durch eine Lebensdauer der photogenerierten Ladungsträger geringer als 10 ps und vorzugsweise geringer als 1 ps gekennzeichnet ist.

4. Photomischer nach Anspruch 3, wobei das photoleitende Material unter dem bei Niedertemperatur epitaxierten AsGa (AsGa-BT), dem $GaSb_xAs_{1-x}$ BT (0<x<1) und dem bestrahlten InGaAs ausgewählt wird.

5. Photomischer nach einem der vorhergehenden Ansprüche, wobei der Photodetektor von einer Art ist, die unter einem Detektor mit Photoleitung und einer Diode mit unipolarem Transport ausgewählt wird.

6. Photomischer nach einem der vorhergehenden Ansprüche, wobei die optische Strahlung eine Infrarotstrahlung ist, die vorzugsweise eine Wellenlänge zwischen 700 und 1600 nm hat.

7. Photomischer nach einem der vorhergehenden Ansprüche, wobei der optische Resonator Resonanzspitzen einer Breite auf halber Höhe von mehr als oder gleich 100 GHz und vorzugsweise mehr als oder gleich 1 THz aufweist.

8. Photomischer nach einem der vorhergehenden Ansprüche, wobei die obere (ES) und untere (EI) Elektrode metallische Elektroden sind.

9. Photomischer nach einem der vorhergehenden Ansprüche, der eine transparente dielektrische Beschichtung (CP) oberhalb der oberen Elektrode (ES) aufweist.

10. Photomischer nach einem der vorhergehenden Ansprüche, wobei die Schicht aus photoleitendem Material (CE) eine Dicke (e) von weniger als 1 μm und vorzugsweise weniger als 500 nm aufweist.

11. Photomischer nach einem der vorhergehenden Ansprüche, wobei die Antenne (AT) zur Terahertz-Strahlung von der Art mit elektromagnetischem transversalem Hornstrahler ist, die eine Grundplatte (PM) und ein Leiterband (RG) aufweist, das sich oberhalb der Grundplatte erstreckt und mit dieser einen spitzen Winkel (φ) bildet.

12. Photomischer nach Anspruch 11, wobei der Photodetektor (PHD) mittels seiner unteren Elektrode (EI) auf ein eigenes dielektrisches oder Halbleiter-Substrat (SS') übertragen wird; wobei die Grundplatte (PM) der Antenne aus einer Verlängerung der Elektrode besteht, die sich oberhalb des Substrats erstreckt, und wobei das Leiterband (RC) sich oberhalb der Grundplatte erstreckt und elektrisch mit der oberen Elektrode verbunden ist.

13. Terahertz-Strahlungsquelle, die einen Photomischer nach einem der vorhergehenden Ansprüche und mindestens eine Laserstrahlungsquelle ($L_1$, $L_2$) aufweist, die eingerichtet ist, um zwei übereinanderliegende Laserstrahlungs-bündel ($F_1$, $F_2$) auf die obere Elektrode des Photodetektors zu richten, wobei die Laserstrahlungsbündel eine Frequenzdifferenz zwischen 100 GHz und 10 THz aufweisen.

14. Verwendung eines Photomischers nach einem der vorhergehenden Ansprüche zur Erzeugung einer Terahertz-Strahlung durch Photomischung.

**Claims**

1. A photomixer for generating THz radiation, the photomixer comprising a photodetector (PHD) coupled to an antenna (AT) for THz radiation, the photomixer being **characterized in that** the photodetector comprises a layer (CE) of photoconductive material suitable for absorbing optical radiation, said layer presenting a thickness ($\underline{e}$) less than the absorption length of said radiation by the photoconductive material and extending between a so-called "top" electrode (ES) that is at least partially transparent and a so-called "bottom" electrode (EI) that is reflective, said bottom and top electrodes forming a resonant cavity for said optical radiation.

2. A photomixer according to claim 1, wherein the photodetector is transferred via said bottom electrode onto a substrate (SS') presenting thermal conductivity that is greater than the thermal conductivity of the photoconductive material.

3. A photomixer according to either preceding claim, wherein said photoconductive material is **characterized by** a lifetime of the photogenerated charge carriers that is shorter than 10 ps, and preferably shorter than 1 ps.

4. A photomixer according to claim 3, wherein said photoconductive material is selected from GaAs grown epitaxially at low temperature (LT-GaAs), LT-GaSb$_x$As$_{1-x}$ (0 < x < 1), and irradiated InGaAs.

5. A photomixer according to any preceding claim, wherein said photodetector is of a type selected from a photoconduction detector and a uni-traveling carrier photodiode.

6. A photomixer according to any preceding claim, wherein said optical radiation is infrared, preferably having a wavelength lying in the range 700 nm to 1600 nm.

7. A photomixer according to any preceding claim, wherein said optical resonator presents resonance peaks having a width at half maximum greater than or equal to 100 GHz and preferably greater than or equal to 1 THz.

8. A photomixer according to any preceding claim, wherein said top and bottom electrodes (ES, EI) are metal electrodes.

9. A photomixer according to any preceding claim, including a transparent dielectric coating (CP) over said top electrode (ES).

10. A photomixer according to any preceding claim, wherein said layer of photoconductive material (CE) presents thickness ($\underline{e}$) less than 1 μm, and preferably less than 500 nm.

11. A photomixer according to any preceding claim, wherein said THz radiation antenna (AT) is of the transverse electromagnetic horn type, having a ground plane (PM) and a conductive stripe (RC) extending over said ground plane and forming an acute angle ($\varphi$) relative thereto.

12. A photomixer according to claim 11, wherein said photodetector (PHD) is transferred onto an intrinsic semiconductor or dielectric substrate (SS') by means of its bottom electrode (EI); wherein the ground plane (PM) of the antenna is constituted by an extension of said electrode, extending over said substrate; and wherein the conductive stripe (RC) extending over said ground plane is electrically connected to said top electrode.

13. A THz radiation source comprising a photomixer according to any preceding claim and at least one laser radiation source ($L_1$, $L_2$) arranged to direct two superposed beams ($F_1$, $F_2$) of superimposed laser radiation onto the top electrode of the photodetector, said beams of laser radiation presenting a frequency difference lying in the range 100 GHz to 10 THz.

14. The use of a photomixer according to any preceding claim for generating THz radiation by photomixing.

Fig.1

Fig.2

Fig.3

Fig.4

Fig.5

Fig.6

Fig.7

Fig.8

$$P_0 = \Im_0 \cdot S$$

ES

$$n_e = n_h$$

d

$$E_0 = \frac{V}{d}$$

$$e \bullet \quad \bullet h$$

$I_{ext}$

V

r

El

## Fig.9

$$\vec{H} = H\vec{y} \qquad \vec{E} = E\vec{x}$$

$$\Im_0 \qquad \vec{k} = k_z\vec{z}$$

$E_0 , H_0$

| $C_1$ | $n_1 - jk_1$ | $t_1$ |

$E_{i-1} , H_{i-1}$

| $C_i$ | $n_i - jk_i$ | $t_i$ |

$E_i , H_i$

| $C_N$ | $n_N - jk_N$ | $t_N$ |

$E_{N+1} , H_{N+1}$

## Fig.10

Fig.11

Fig.12

Fig.13

Fig.14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5455421 A

- FR 2908931

**Littérature non-brevet citée dans la description**

- **E. R. BROWN ; K. A. MCLNTOSH ; K. B. NICHOLS ; C. L. DENNIS.** Photomixing up to 3.8 THz in low-temperature-grown GaAs. *Appl. Phys. Lett.,* 1995, vol. 66, 285
- **FURUTA, T. ; YOSHINO, K. ; HIROTA, Y. ; ISHIBASHI, T.** Photonic Terahertz-wave génération using antenna-integrated. *Electronics Letters,* 11 Décembre 2003, vol. 39 (25), 1828-1829
- Optical and Terahertz power limits in the low-temperature-grown GaAs photomixers. *Appl. Phys. Lett.,* 1997, vol. 71, 2743

- **E. A. MICHAEL ; B. VOWINKEL ; R. SCHIEDER ; M. MIKULICS ; M. MARSO ; P. KORDOS.** Large-area travelling-wave photonic mixers for increased continuous Terahertz power. *Appl. Phys. Lett.,* 2005, vol. 86, 111120
- **M. MIKULICS ; E. A. MICHAEL ; R. SCHIEDER ; J. STUTZKI ; R. GUSTEN ; M. MARSO ; A. VAN DER HART ; H. P. BOCHEM ; H. LUTH ; P. KORDOS.** Travelling-wave photomixer with recessed interdigitated contacts on low-temperature-grown GaAs. *Appl. Phys. Lett.,* 2006, vol. 88, 041118
- **MICHAEL N. FEIGINOV.** Analysis of limitations of terahertz p-i-n uni-traveling-carrier photodiodes. *J. Appl. Phys.,* 2007, vol. 102, 084510